Europäisches Patentamt

European Patent Office

Office européen des brevets

(11) Publication number: **0 069 190**
**A2**

(12) **EUROPEAN PATENT APPLICATION**

(21) Application number: 82100735.8

(22) Date of filing: 02.02.82

(51) Int. Cl.³: **H 01 H 13/70**
**H 03 K 17/965**

(30) Priority: 29.06.81 US 278658

(43) Date of publication of application:
12.01.83 Bulletin 83/2

(84) Designated Contracting States:
AT BE DE FR GB IT LU NL

(71) Applicant: W.H. Brady Co.
727 West Glendale Avenue
Milwaukee Wisconsin 53201(US)

(72) Inventor: Frame, Norman Joseph
4832 North Shoreland Avenue
Whitefisch Bay Wisconsin 53217(US)

(72) Inventor: Walber, James Peter
326 Couth 6th Street
Cedar Grove Wisconsin 53013(US)

(74) Representative: Heidrich, Udo, Dr. jur., Dipl.-Phys.
Franziskanerstrasse 30
D-8000 München 80(DE)

(54) Capacitance switch.

(57) A capacitance-type switch practical for membrane devices sealed against dust and fluid.

FIG 2

EP 0 069 190 A2

- 1 -

## CAPACITANCE SWITCH

### Field of the Invention

This invention relates to capacitance-type switches.

I have discovered that an improved capacitance-type switch can be provided if an electrically integral capacitance spacing layer is provided over a plurality of switch zones.

In another aspect of my invention, I had found that membrane capacitance-type switches may be usably and desirably provided.

In preferred embodiments of my invention, I provide at one end of the capacitance spacer a folded-over portion; I use a screened insulating epoxy resin as a mechanical spacer; and I use a layer comprising indium to facilitate electrical connecting.

I have discovered that by providing a second contact aligned with and ordinarily spaced from a movable contact and electrically connected to a conductive portion of a capacitance spacing element, the capacitance spacing element can be located other than directly adjacent the contacts, and switching elements remotely spaced from one another can share a common capacitance spacing element. Thus, it is possible to have increased manufacturing flexibility in locating the positions of the switching elements at the same time that the capacitance spacing elements are being used efficiently and the size of the switching matrix and detection circuitry may be kept down.

Devices according to my invention have many

— 2 —

advantages. Because the area of the capacitance spacer layer is increased, the difference between unactuated and actuated capacitance is greater, for a greater signal-to-noise ratio. Furthermore, in its membrane switch aspect there is provided a sealed capacitance-type switch, protected against dust and vapors. Long life is provided. Because current flows can be made extremely small, not only can much smaller quantities of metal be used for conductors and contacts, but less expensive, non-precious metals may be used for the most part. Other advantages will appear in the following discussion.

### Preferred Embodiments

I turn now to presently preferred embodiments of the invention.

There is shown:

Fig. 1 is a plan view of a preferred embodiment of the invention.

Fig. 2 is an enlarged cross-sectional view, taken at 2-2 of Fig. 1.

Figs. 3A through 3G illustrate steps in the manufacture of said preferred embodiment.

Fig. 4 is a circuit diagram of a detection circuit for said preferred embodiment.

Fig. 5 is an enlarged sectional view, taken at 5-5 of Fig. 1, through the joint between the tail and tail extender.

Fig. 6 is a vertical sectional view, taken at 1-1 of Fig. 6 through a pair of adjacent switching elements, of a portion of a capacitance switch according to the invention.

Fig. 7 is a plan view, partially broken away, of a capacitance switch according to the invention.

- 3 -

Fig. 8 is a plan view of a transparent sheet of said capacitance switch shown with conductive portions on its lower surface.

Fig. 9 is a plan view of the bottom sheet of said capacitance switch shown with conductive portions and capacitance elements on its upper surface.

## Description

Turning now to the drawings, there is shown a membrane switch (i.e., a switch in which a flexible layer is flexed in order to produce a signal output) in which the signal output is produced by a large change in capacitance.

The device may perhaps be most understandably explained by an initial description of how it is made.

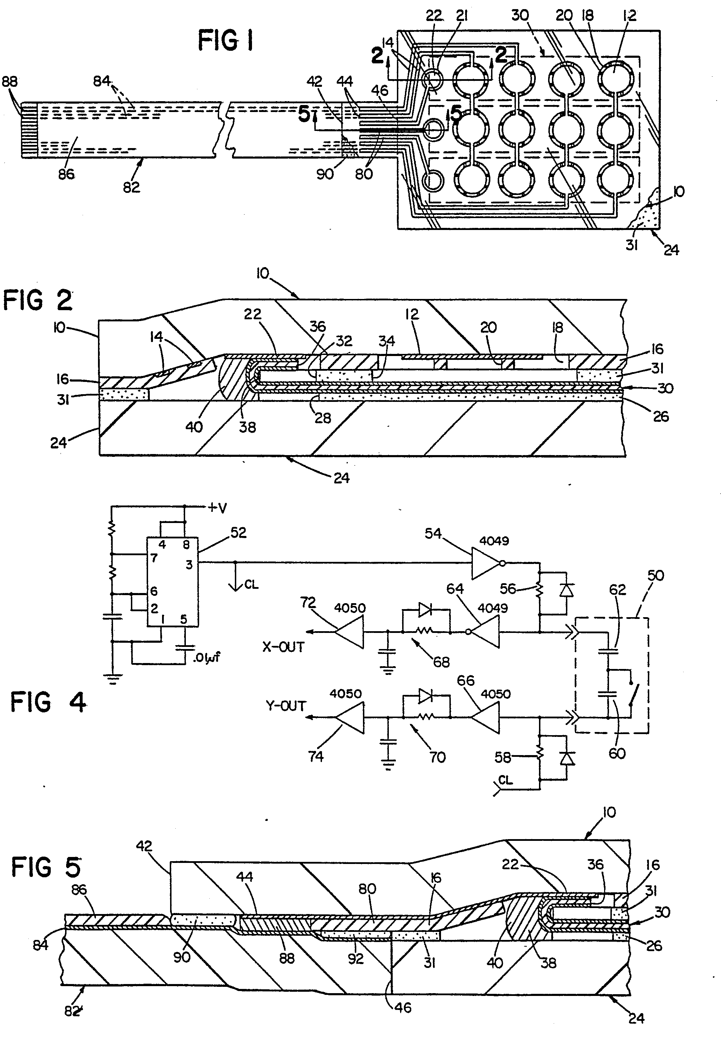

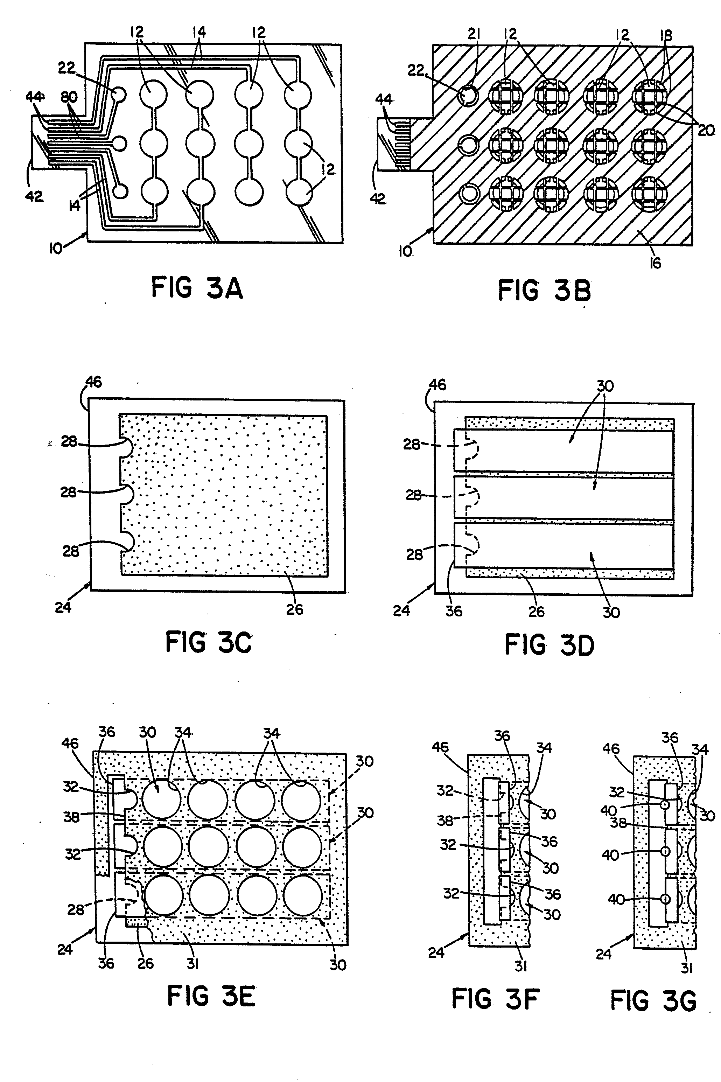

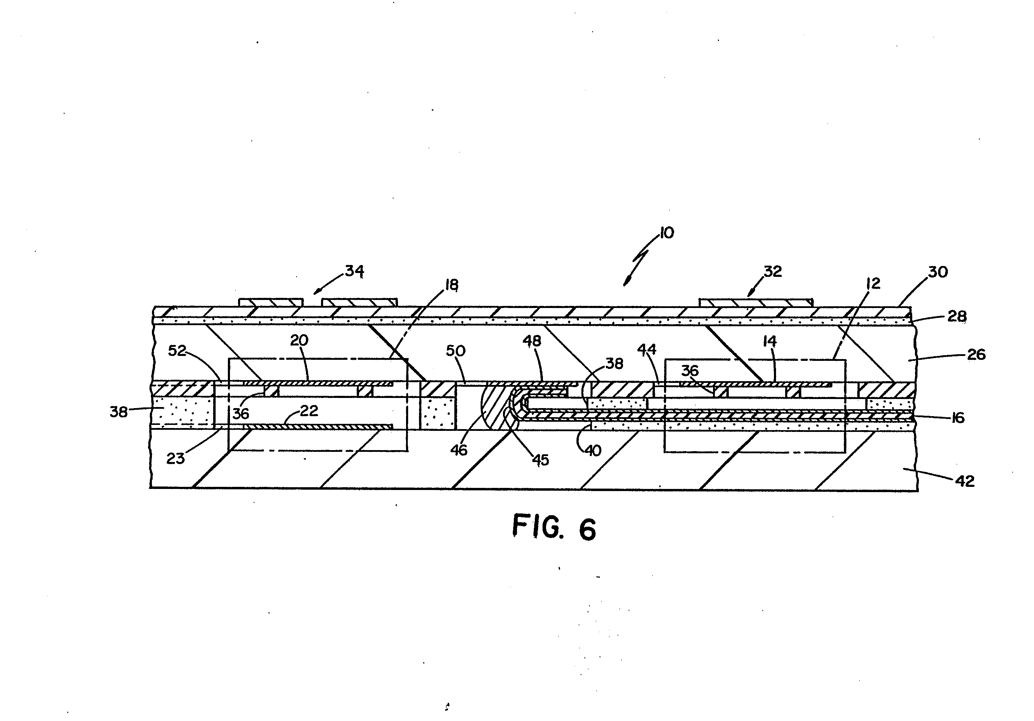

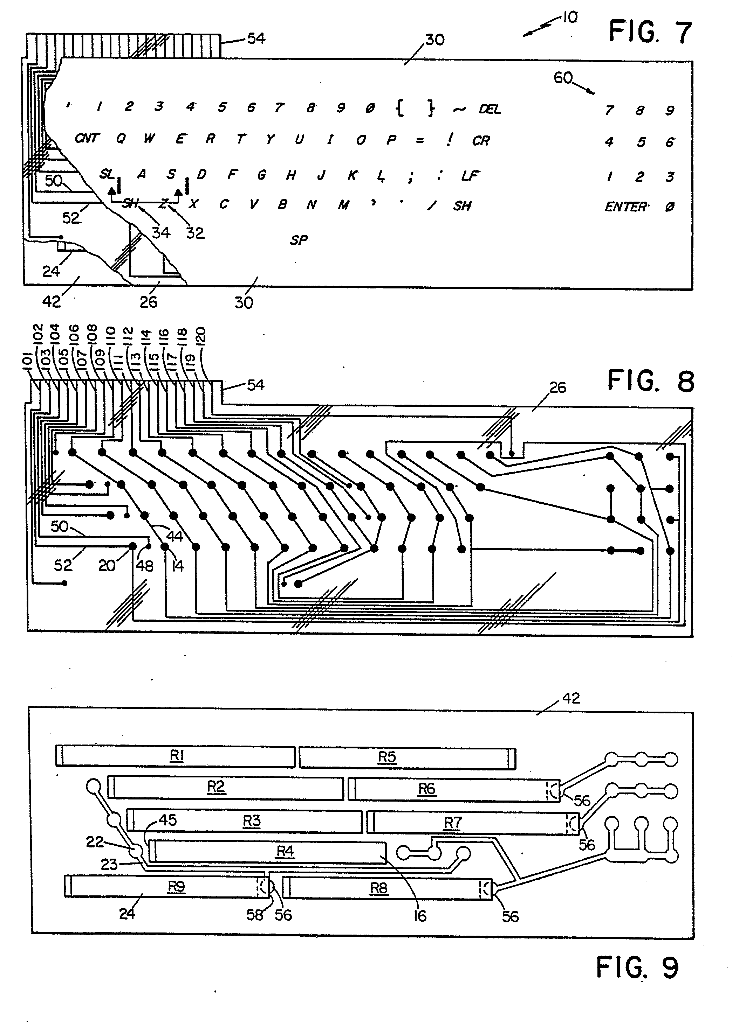

There is shown in Fig. 3A a bottom plan view of top layer 10. It comprises 5-mil thick transparent polyester layer 10, on the bottom surface of which has been vacuum deposited thereon through a suitable mask of multiplicity of round pads 12 and conductors 14, of copper, 1500 Ångstrom units thick.

Fig. 3B is a bottom view of said top layer 10 showing positioned over the surfaces, including the pads and connectors, illustrated in Fig. 3A, a layer 16 of insulating epoxy (one mil thick), ultraviolet curable and capable (like the other elements of the switch) of withstanding elevated temperature and humidity (e.g., 85°C and 85% R.H.), screened through a mask prior to curing, and including a multiplicity of zones 18 in which, corresponding with the locations of pads 12, the epoxy is laid down, not in an uninterrupted layer as throughout most of the device, but in sets of grid lines 20. The layer of epoxy is also relieved at three areas 21, corresponding with the location of contact areas 22 (shown in Fig. 3A).

Fig. 3C is a plan view of bottom layer 24, also of five mil thickness transparent polyester film, on which has been deposited, through a mask, a 1/2-mil thick layer 26 of pressure-sensitive acrylic adhesive, interrupted by generally circular zones 28 corresponding to the locations of conducting pad zones 22 on the top layer 10.

Fig. 3D is a plan view of the bottom layer 24 following the next step in the manufacturing process, namely, the assembly of the three elongated strips 30, which are held in place by adhesive layer 26, and are formed from 1/4-mil polyester on each outer surface of which is vacuum deposited by RF sputtering layers 1000 Ångstrom units in thickness of aluminum.

Fig. 3E is a plan view of bottom layer 24 after the next step in manufacture of the device. In this step there is deposited through a mask, over the area indicated in dots, a layer 31 of acrylic pressure-sensitive adhesive one mil in thickness. As shown in the drawings, this step leaves uncoated areas 32 corresponding to the contact areas 22 in top element 10 and areas 34 corresponding to the pads 12 of element 10.

The step just described leaves extending freely the tips 36 of strips 30. These tips are then folded up around edges 38 of adhesive layer 31, as illustrated in Fig. 3F, as well as in Fig.

- 5 -

2. Dots 40 of a silver filled conductive epoxy (Amicon 3050, sold by Amicon Corporation of Lexington, Massachusetts) are then deposited along the fold line of the strips 30, to supplement conductivity through the outer aluminum layers of strips 30 and make contact with pads 22.

The steps thus far described are carried out on the top and bottom elements (to be assembled into the switch) separately, and while each is part of a web of greater width than the final width dimension of the switch. In the top element, portions to define the tail 42 are cut out before the upper and lower portions are assembled. Also before assembly a cut is made to define edge 46 of the lower portion as well as a window of which the edge 46 is one of the four sides to permit movement therethrough for soldering of tail 42. They are then assembled, and held together by adhesive layer 31. Next they pass over a roller which causes tail 42 to extend in a direction facilitating adding thereto, over the conductor areas 44, by standard solder wave techniques, one mil thick layer of 50% indium–50% tin alloy. (This approach permits use of a very short integral tail, with consequent savings of expensive polyester; as long a tail as desired may then be attached through an alloy seal with a similar alloy on the tail extended; the seal can be simply effected by a pressure-heat step–– 50 psi at 125° Centigrade for half a second.) The construction at the tail-extender joint is shown in Fig. 5, in which is seen switch top layer 10 bearing conductive tracks 80 and insulat-

- 6 -

ing layer 16, extending over sw'tch bottom layer 24. Tail extender 82 initially carries copper track 84 protected with epoxy layer 86 and an indium-tin layer over the tracks at their ends to enable making the seal. The indium-tin layer 88 is created by fusion pursuant to pressure of the indium-tin layer carried by tail 42 and the indium-tin layer carried by extender 82. Adhesive strips 90 and 92 cooperate to aid in maintenance of the seal.

A suitable detection circuit is disclosed in Fig. 4. A single switch shown as indicated at 50 corresponds to one of the 12 switching areas shown in the preferred embodiment. Clock 52 sends out square wave pulses at a frequency of 2kHz through inverter 54 and resistance 56 into one side of switch 50 and simply through resistance 58 into the other. So long as the switch 50 is not actuated, so that both air capacitor 60 and polyester capacitor 62 are in the circuit, current flows through inverter 64 and transmission gate 66 are insufficient to transmit signals past RC networks 68 and 70. When the air capacitor 60 is taken out of the circuit by pressing the appropriate area, signals do pass RC networks 68 and 70, providing output signals at transmission gates 72 and 74, the former providing information, in the preferred embodiment, of the X position of the switch pressed, and transmission gate 74 providing similar information as to the Y position.

In operation, a pad 12 is pushed downwardly by flexing flexible layer 10, which carries it, until pad 12 engages a strip 30. (The amount of

- 7 -

force required to do this may be regulated partially by the spacing of epoxy grid lines 20; the more closely spaced are the grid bars 20, the more difficult is it to push down layer 10 and pad 12 between them to engage strip 30.) This in effect eliminates one of two capacitors in series (the air capacitor 60), leaving the polyester capacitor, causing the capacitance of the circuit through this contact made to increase enormously. In the preferred embodiment just described the capacitance increases from 30 picofarads to 10 nanofarads--i.e., over three hundred times.

### Other Embodiments

Other embodiments within the invention will occur to those skilled in the art. For example only, I mention a few. For the polyester layer producing the large capacitance could be substituted, for example, a deposited layer of tantalum pentoxide, which has a dielectric constant many times that of polyester. Instead of insulating epoxy a diecut polyester spacer could be used. Conductor areas could be made by printing or etching. The polyester capacitor strip could be folded on itself to produce increased capacitance. Instead of being constructed in the X-Y matrix disclosed the device could be a common ground one, with a separate lead coming off each conductive pad; here the other lead to all the pads might desirably be a single large capacitor spacer (as opposed to the three strips shown in the embodiment described). The entire device could be made transparent, so that it might be mounted on the face of a CRT. The substrate of

- 8 -

the device could be made rigid. In another embodiment, the capacitor spacing layer is a single sheet substantially the size of the overall device and located in it below a layer carrying on it a plurality of X-row pads and beneath it a layer of Y-column pads, with spacers between the central layer and each of the other two.

One further embodiment is disclosed in detail. Referring to Fig. 6, there is shown a portion of capacitance switch 10 having switching elements arranged in positions corresponding to positions of keys of a computer terminal. Switch 10 has a plurality of switching elements with their movable contacts located directly over elongated capacitance spacing elements (e.g., switching element 12 with movable contact 14 over elongated capacitance spacing element 16) and a plurality of switching elements horizontally spaced from their associated elongated capacitance spacing elements (e.g., switching element 18 with movable upper contact 20 over lower contact 22 connected by conductor 23 to elongated capacitance spacing element 24--Fig. 9).

Movable contacts 14, 20 are copper pads vacuum-deposited on the lower surface of flexible polyester sheet 26. Adhered above layer 26 by adhesive layer 28 is plastic overlay 30 having indicia inked thereon, index 32 being the letter "z", index 34 being the symbol "SH". (See Fig. 7.) On the bottom surface of flexible sheet 26 and contacts 14, 20 is cured epoxy layer 36, which is interrupted in the switching element regions to leave the majority of the lower surfaces of contacts 14, 20 exposed. Elongated capacitance spacing element 16 is adhered therebelow by adhesive layer 38 and consists of 1/4 mil thick polyester with RF sputtered layers of aluminum on the upper and lower surfaces. The bottom surface of capacitance spacing element 16 is attached by adhesive layer 40 to bottom polyester sheet 42. ·Contact 22 is carried by bottom sheet 42.

Each switching element includes an air capacitor (e.g., contact 20 separated from contact 22 by air; contact 14 separated from upper conductive surface of capacitance spacing element 16 by air) of low capacitance connected in series with a polyester capacitor (e.g., large-area capacitance spacing element 16) of high capacitance. The capacitances of the switching elements are thus low when the contacts are in the ordinarily open positions shown in Fig. 6, and high when the air capacitors are short-circuited by bringing the upper movable contacts in electrical engagement with the upper surfaces of their associated capacitance switching elements.

Connections to external circuitry are provided by conductors carried by the lower surface of polyester sheet 26 (Figs. 6 and 8). Contact 14 is connected to column conductor 44. The lower aluminum surface of capacitance spacing element 16 is connected at its folded-over end 45 by conductive epoxy 46 and conductive pad 48 to row conductor 50. Contact 20 is connected to column conductor 52. Row conductor 50, column conductors 44, 52 and other similar conductors are all connected to tail 54 for connection to external circuitry.

- 10 -

Fig. 7 shows overlay 30 with its indicia associated with the plurality of switching elements, and Fig. 8 shows transparent flexible sheet 26 with conductive members on its bottom, the contacts being in the same orientation as their associated indicia shown in Fig. 7. The conductive members include a plurality of movable contacts (e.g., larger circles similar to contacts 14, 20), row conductive pads (e.g., smaller circles similar to conductive pad 48), and conductive lines (e.g., conductive lines 44, 50, 52) ending at tail 54.

Fig. 9 shows bottom layer 42 with nine elongated capacitance spacing elements designated $R_1$ through $R_9$ to indicate rows of switching elements, lower switch contacts (e.g., contact 22), lower contact pads 56 (similar to conductive pad 48), and conductive lines (e.g., line 23). A vertical solid line on a capacitance spacing element indicates that the element is folded over upward, as element 16 (also designated $R_4$) is, to make electrical contact of the lower conductive surface with a pad on the bottom of upper sheet 26. A vertical dashed line on a capacitance spacing element indicates that the element is folded over downward to make contact of its upper conductive surface with a pad 56 on bottom sheet 42; e.g., the upper surface of end 58 of row 9 is electrically connected to pad 56 with conductive epoxy similar to epoxy 46. The folded over construction of capacitance spacing elements permits carrying all of the conductors for connection to external circuitry by flexible polyester sheet 26. The folded over construction also provides a simple connection between the upper surfaces of the capacitance spacing elements and the remotely located contacts.

The following table lists the numerical designation for conductors on tail 54 in Fig. 8 associated with the rows and the columns of the switch contacts and switching elements.

| Tail Conductor Designation | Row or Column |
|---|---|
| 101 | Row 9 |
| 102 | Shift Column |
| 103 | Row 4 |
| 104 | Shift Lock Column |
| 105 | Row 3 |
| 106 | Row 2 |
| 107 | Control Column |
| 108 | Row 1 |
| 109 | Column 1 |
| 110 | Column 2 |
| 111 | Column 3 |
| 112 | Column 4 |
| 113 | Column 5 |
| 114 | Column 6 |
| 115 | Column 7 |
| 116 | Row 8 |
| 117 | Column 8 |
| 118 | Row 7 |
| 119 | Row 6 |
| 120 | Row 5 |

The following tables present the row and column information for the switching element indicia. Subscripts next to numbers indicate numerical computation indicia 60 for switching elements located to the right of the switching elements associated with typewriter key indicia (Fig.7).

— 12 —

| Row | Column | | | | | | | |
|-----|---|---|---|---|---|---|---|---|
| | 1 | 2 | 3 | 4 | 5 | 6 | 7 | 8 |
| 1 | ' | 1 | 2 | 3 | 4 | 5 | 6 | 7 |
| 2 | Q | W | E | R | T | Y | U | I |
| 3 | A | S | D | F | G | H | J | K |
| 4 | Z | X | C | V | B | N | M | , |
| 5 | | DEL | ~ | -{ | }- | Ø | 9 | 8 |
| 6 | $9_1$ | $8_1$ | $7_1$ | CR | ! | = | P | O |
| 7 | | $6_1$ | $5_1$ | $4_1$ | LF | : | ; | L |
| 8 | | $3_1$ | $2_1$ | $1_1$ | ENTER | / | . | |

| Row | Column | | |
|-----|---|---|---|
| | Shift Key Column | Shift Lock Column | Control Column |
| 9 | SH | SL | CNT |

It is seen that an eight by eight X-Y matrix results for the majority of indicia and their associated switching elements. For example switching element 12 ("Z") corresponds to row 4 (tail conductor 103) and column 1 (tail conductor 109). The three switching elements in row 9 have columns exclusively used by a single switching element. For example, switching element 18 ("SH") corresponds to row 9 (tail conductor 101), and the "Shift" column (tail conductor 102).

By providing lower contacts that are electrically connected to their associated capacitance spacing elements, manufacturing flexibility is greatly increased in that the contacts do not have to be placed directly over the associated capacitance spacing elements. Thus switching elements spaced from each other on the switch can share a common capacitance spacing element. For example, the numerical computation switching elements associated with indicia 60 on the right side of Fig. 7 are all connected to the capacitance spac-

- 13 -

ing elements designated rows 6, 7 and 8 (Fig. 9). This permits using the capacitance spacing elements efficiently and keeping the size of the switching matrix and detection circuitry down.

In operation a switching element is activated by depressing overlay 30 at a location associated with an index. For example if overlay 30 is depressed at index 32, contact 14 engages the upper surface of capacitance spacing element 16, and this in effect eliminates one of the two capacitors in series (air capacitor between contact 14 and the upper conductive surface of element 16), leaving the polyester capacitor (capacitance spacing element 16), and causing the capacitance of the circuit through switching element 12 to increase enormously. The increase of capacitance appears between tail conductor 103 and tail conductor 109 and is detected by the detection circuitry (not shown) as row 4, column 1. Similarly, if switching element 18 is activated by depressing overlay 30 at the location of index 34, contact 20 engages contact 22, again eliminating the air capacitor, leaving the polyester capacitor (capacitance spacing element 24), and causing the capacitance of circuit between tail conductors 101 and 102 to increase enormously. This increase in capacitance is detected by the detection circuitry as row 9 and the "Shift" column. The operation of the switching elements associated with the other indicia on Fig. 7 is similar.

Other embodiments are within the scope of the appended claims.

What is claimed is:

- 14 -

## Claims

1. A membrane capacitance switch comprising: a substrate sheet, a flexible sheet extending over said substrate sheet, a conductive contact carried by one of said substrate sheet and said flexible sheet, a capacitance spacing element carried by the other of said substrate sheet and said flexible sheet and located alongside and spaced from said conductive contact, said capacitance spacing element comprising an inner insulating layer and outer conductive portions, whereby said flexible sheet may be flexed to vary the spacing of said conductive contact and said capacitance spacing element.

2. The membrane capacitance switch of claim 1 in which are provided a plurality of conductive contacts and in which an integral capacitance spacing element extends over said plurality.

3. The membrane capacitance switch of claim 1 in which said capacitance spacing element comprises a layer of plastic and said outer conductive portions comprise layers of metal.

4. The membrane capacitance switch of claim 3 in which said plastic is polyester.

5. The membrane capacitance switch of claim 4 in which said metal is sputtered aluminum.

6.  The membrane capacitance switch of claim 1 in which said capacitance spacing element is carried by said substrate.

7.  The membrane capacitance switch of claim 6 in which said capacitance spacing element is secured with respect to said substrate by means of a layer of adhesive.

8.  The membrane capacitance switch of claim 7 in which a spacer lies between said flexible sheet and said substrate and in which said capacitance spacing element is bent around said spacer at an end thereof.

9.  The membrane capacitance switch of claim 8 in which said capacitance spacing element is adhered to said spacer on the side of said spacer away from said substrate.

10.  The membrane capacitance switch of claim 8 in which said flexible sheet carries a contact pad engaging said capacitance spacing element on its face away from said substrate.

11.  The membrane capacitance switch of claim 1 comprising a plurality of said capacitance spacing elements, each thereof extending over a plurality of conductive contacts.

12. The membrane capacitance switch of claim 8 in which a conductive element extends along said bent portion and to a second conductive contact carried by one of said substrate sheet and said flexible sheet.

13. The switch of claim 1 in which said inner insulating layer and said outer conductive portions are integral.

14. A capacitance-type switch in which an electrically integral capacitance spacing layer extends through a plurality of switch zones, and is separately movable in a switching direction at each of said switch zones.

15. A capacitance switch comprising: a substrate sheet, a flexible sheet extending over said substrate sheet, a conductive contact carried by one of said substrate sheet and said flexible sheet, a capacitance spacing element carried by the other of said substrate sheet and said flexible sheet and located alongside and spaced from said conductive contact, said capacitance spacing element comprising an inner insulating layer and outer conductive portions, whereby said flexible sheet may be flexed to vary the spacing of said conductive contact and said capacitance spacing element, in which a spacer lies between said flexible sheet and said substrate and in which said capacitance spacing element is bent around said spacer in a fold portion at an end thereof, said spacer being centrally spaced from said fold portion.

16.    The switch of claim 15 in which said spacer comprises adhesive material.

17.    The switch of claim 16 in which said spacer is centrally semi-circularly relieved adjacent said fold portion.

18.    The switch of claim 17 in which the transverse edges of the end of said spacer including said relieved portion of said spacer engages said fold portion.

19. The capacitance switch of claim 1 or claim 14 which has one capacitance value in an activated condition and a different capacitance value in a deactivated condition, the circuitry comprising a source supplying a first clock node and a second clock node with two-state electrical pulses 180° out of phase, first and second switch connection nodes for connecting a switching element in said capacitance switch to said circuitry, a buffer having an input connected to said first switch connection node, and providing an output signal depending upon the condition at said buffer input relative to a threshold value, means connected between said clock nodes and said switch connection nodes for responding to the capacitance associated with one condition of said switch by maintaining said buffer input at a condition relative to said threshold value of said buffer and for responding to a capacitance associated with another condition of said switch by permitting the condition at said buffer input to vary sufficiently to cause the output of said buffer to vary with said two-state pulses, and a frequency detector connected to said buffer, to determine which condition said capacitance switch is in.

20. The circuitry of claim 19 wherein said means connected between said clock nodes and switch connection nodes comprises a first high impedance path between said first clock node and said first switch connection node, a second high impedance path between said second clock node and said second switch connection node, a first unidirectional, low impedance path between said first clock node and said first switch connection node, and a second unidirectional, low impedance path between said second clock node and said second switch connection node, one said low impedance path permitting current flow to its respective switch connection node and the other said low impedance path permitting current flow away from the other said switch connection node.

21. The circuitry of claim 20 wherein said frequency detector comprises a resistor connected at one end to an output of said buffer and at the other end to a gate input, a detecting capacitor, and means for draining said capacitor when the output signal of said buffer is low.

22. The circuitry of claim 21 wherein said high impedance paths are resistors and said unidirectional low impedance paths are diodes.

23. The circuitry of claim 21 or 22 wherein said means for draining is a diode connected to said buffer output.

24. The circuitry of claim 19 wherein said switch contains a row with a plurality of switching elements, each having a conductive pad electrically common with pads of the other switches and a pad having its own conductor isolated from conductors for other switching elements, and said circuit contains a first switch connection, buffer, means connected between clock nodes and switch connection nodes, and frequency detector for each said switching element in said row.

25. The circuitry of claim 24 wherein said switch includes a plurality of rows of said switching elements resulting in an X by Y matrix of switching elements, and said circuit contains a second said switch connection, a buffer, means connected between clock nodes and switch connection nodes, and a frequency detector for each said row.

26. A capacitance switch comprising a substrate, a first conductive contact carried by said substrate, a flexible sheet extending over said substrate, a second conductive contact carried by said flexible sheet and aligned with and ordinarily spaced from said first contact, a capacitance spacing element carried by one of said substrate and said flexible sheet, located other than directly under or above said contacts, said capacitance spacing element comprising an inner insulating layer and outer conductive portions, one said conductive portion being electrically connected to one said contact, and first means for connection of the other said contact and the other said conductive portion to external circuitry, whereby said flexible sheet may be flexed to vary the spacing between said contacts to increase the capacitance of said switch.

27. The switch of claim 26 further comprising a third contact carried by the other of said substrate and said flexible sheet that said capacitance spacing element is carried by, said third contact being electrically connected to second means for connection to external circuitry and being aligned with and ordinarily spaced from said conductive portion not electrically connected to said first means for connection to external circuitry, whereby said flexible sheet may be flexed to vary the spacing between said third contact and said capacitance spacing element.

- 22 -

28. The switch of claim 27 further comprising a fourth contact carried, connected, and positioned similarly to said third contact and spaced from said third contact.

29. The switch of claim 28 further comprising a plurality of said capacitance spacing elements and fifth contacts associated with said plurality of capacitance spacing elements, some of said fifth contacts being aligned with and ordinarily spaced from conductive portions of said plurality of capacitance spacing elements, some of said fifth contacts being aligned in ordinarily spaced pairs and being remotely located from but electrically connected to their associated capacitance spacing elements.

30. The switch of claim 29 wherein said contacts are arranged in positions corresponding to positions of typewriter keys, said capacitance elements being aligned with rows of said typewriter key positions.

31. The switch of claim 30 wherein sixth contacts are provided and arranged in pairs in positions corresponding to positions of numerical computation keys, said sixth contacts being located remotely on said switch from said contacts having positions corresponding to said positions of typewriter keys, one said contact of each said pair being electrically connected to a conductive portion of a capacitance spacing element aligned with a corresponding typewriter row.

32. The switch of claim 26 wherein an end of said capacitance spacing element is folded over in the direction away from the sheet that carries it, and said other said conductive portion is in electrical communication with a conductor carried by the sheet that said spacing element is not carried by, whereby all conductors comprising electrical connections to external circuitry can be carried by a single sheet.

33. The switch of claim 32 wherein another end of said capacitance spacing element is folded over in the direction toward the sheet that carries it, and said one conductive portion is in electrical communication with a conductor carried by the sheet and electrically connected to said one contact.

0069190

114

FIG 1

FIG 2

FIG 4

FIG 5

0069190

FIG 3A

FIG 3B

FIG 3C

FIG 3D

FIG 3E

FIG 3F

FIG 3G

0069190

FIG. 6

FIG. 7

FIG. 8

FIG. 9